# DEMANDE DE BREVET EUROPEEN

(11) **EP 0 603 039 A1**
(43) Date de publication de la demande: **22.06.1994**
(21) Numéro de dépôt: 93402992.7
(22) Date de dépôt: 13.12.1993
(51) Int. Cl.: H03K 17/96

(54) **Clavier pour environnement sévère et appareil de cuisson comportant un tel clavier**

(30) Priorité: 14.12.1992 FR 9215014
(71) Demandeur: JAEGER REGULATION Société Anonyme, F-28000 Chartres (FR)
(72) Inventeur: Stahl, André, F-28170 Favières (FR); Gaignard, Philippe, F-28150 Voves (FR)
(74) Mandataire: Orès, Bernard

(57) **Abrégé**

L'invention se rapporte principalement à un clavier pour environnement sévère et à un appareil de cuisson comportant un tel clavier.

L'invention a pour objet un clavier de commande comportant un générateur haute fréquence ou un générateur radio fréquence (5) notamment un générateur accordé sur une fréquence comprise entre 150 kHz et 1,2 MHz et au moins une touche comprenant au moins une antenne d'émission (7) d'ondes électro-magnétiques hautes fréquences ou d'ondes radio électriques raccordées audit générateur (5), caractérisé en ce que ladite touche comporte une antenne de réception (8) placée au droit de l'emplacement de détection de la présence d'un doigt (16) de commande et des moyens de comparaison (31, 40) du niveau du signal recueilli par ladite antenne de réception (8) par rapport à une valeur de référence ou à un intervalle de valeurs de référence.

L'invention s'applique principalement à la réalisation de claviers pour tables de cuisson à plaques supérieures en vitro-céramiques et à des fours pour cuisson d'aliment.

## Description

L'invention se rapporte principalement à un clavier pour environnement sévère et à un appareil de cuisson comportant un tel clavier.

Les appareils domestiques ou industriels sont fréquemment commandés par des claviers.

L'on utilise habituellement un clavier étanche pour éviter les agressions en environnement sévère ou pour protéger le milieu contre un risque d'explosion provoquée par le fonctionnement du clavier.

L'on a proposé dans la Demande de Brevet FR-2 658 591 d'équiper les tables de cuisson à plaques supérieures vitro-céramiques avec un clavier mettant en oeuvre un couplage capacitif entre le doigt de l'opérateur et un condensateur placé sous la plaque de cuisson.

Dans la Demande de Brevet FR-2 661 575, l'on a proposé d'utiliser des touches émettant un rayonnement radio-électrique haute-fréquence. Le niveau du signal dans le circuit d'émission est mémorisé par un circuit intégrateur. La présence d'un doigt de l'opérateur jouant le rôle d'antennes de réception introduit une variation du niveau du signal dans la touche, cette variation étant détectée par des comparateurs.

Le niveau du signal mémorisé est composé avec celui du signal dans le circuit d'émission. Ce dispositif d'un prix de revient élevé présente plusieurs inconvénients.

Lors de l'initialisation du système, il existe un temps d'adaptation que l'on peut estimer être de l'ordre de 5 secondes pendant lequel le circuit intégrateur doit mémoriser le niveau du signal en absence du doigt de l'opérateur pour que ce dispositif puisse fonctionner.

De même, lorsque l'opérateur maintient son doigt sur la touche pendant un intervalle de temps supérieur ou égal au temps d'intégration, les niveaux du signal provenant du circuit intégrateur et du signal direct deviennent égaux et la présence du doigt devient indétectable. Ce système ne fonctionne donc qu'en mode impulsionnel difficilement maîtrisable par un opérateur non qualifié.

D'autre part, la Demande de Brevet FR-2 606 162 décrit un capteur de proximité pour la télédétection comportant une antenne d'émission et une antenne de réception travaillant à une fréquence comprise entre 100 et 500 MHz. Une personne ou un objet est détecté par la variation de capacité induite dans le circuit.

C'est par conséquent un but de la présente invention d'offrir un clavier étanche par rapport à son environnement susceptible de fonctionner avec une fiabilité élevée en environnement sévère.

C'est également un but de la présente invention d'offrir un clavier facile à utiliser.

C'est aussi un but de la présente invention d'offrir un clavier facile à mettre en oeuvre dans un dispositif, notamment dans une table de cuisson de type à plaque supérieure vitro-céramique.

C'est également un but de la présente invention d'offrir un appareil de cuisson comportant un tel clavier permettant le réglage de la puissance moyenne des éléments chauffants.

C'est aussi un but de la présente invention d'offrir un tel appareil de cuisson utilisant un courant de commande faible.

Ces buts sont atteints par un clavier selon l'invention dont chaque touche comporte un émetteur de rayonnement radio-électrique haute fréquence et une antenne de réception, les signaux transmis entre l'émetteur et le récepteur étant modifiés, notamment atténués par la présence du doigt de l'opérateur au droit de la touche.

L'invention a principalement pour objet un clavier de commande comportant un générateur haute fréquence ou un générateur radio fréquence notamment un générateur accordé sur une fréquence comprise entre 150 kHz et 1,2 MHz et au moins une touche comprenant au moins une antenne d'émission d'ondes électro-magnétiques hautes fréquences ou d'ondes radio électriques raccordées audit générateur, caractérisé en ce que ladite touche comporte une antenne de réception placée au droit de l'emplacement de détection de la présence d'un doigt de commande et des moyens de comparaison du niveau du signal recueilli par ladite antenne de réception par rapport à une valeur de référence ou à un intervalle de valeurs de référence.

L'invention a également pour objet un clavier, caractérisé en ce que l'amplitude du signal capté par l'antenne de réception est réduite par la présence d'un doigt placé au droit de l'emplacement de détection.

L'invention a également pour objet un clavier, caractérisé en ce que l'antenne d'émission est une self-inductance imprimée sur une première face d'un circuit imprimé et en ce que l'antenne de réception est imprimée en vis à vis sur la seconde face du circuit imprimé.

L'invention a également pour objet un clavier, caractérisé en ce que la sortie du générateur haute fréquence ou radio fréquence est connectée en parallèle aux entrées d'un condensateur et d'une self-inductance formant une antenne d'émission, les sorties du condensateur et de la self-inductance étant reliées à une première borne d'une première polarité d'une alimentation électrique, et en ce que l'antenne de réception est connectée à l'entrée d'un condensateur dont la sortie est connectée en parallèle à l'entrée d'une première résistance et à l'entrée d'une diode, la sortie de la première résistance étant connectée à une deuxième borne d'une seconde polarité de l'alimentation électrique, la sortie de la diode étant connectée à la deuxième borne de seconde polarité de l'alimentation électrique par un condensateur et aux moyens de comparaison du niveau du signal à une valeur de référence.

L'invention a également pour objet un clavier, caractérisé en ce que les moyens de comparaison du niveau du signal recueilli par l'antenne de réception d'une touche par rapport à une valeur de référence comporte un comparateur.

L'invention a également pour objet un clavier, caractérisé en ce que les moyens de comparaison du niveau du signal recueilli par une antenne de réception par rapport à une valeur de référence comportent des moyens de numérisation du signal et un micro-processeur ou un micro-contrôleur.

L'invention a également pour objet un clavier, caractérisé en ce qu'il comporte un multiplexeur dont ies entrées sont connectées aux diverses antennes de réception des diverses touches du clavier et dont la sortie est connectée audit micro-contrôleur ou micro-processeur.

L'invention a également pour objet un appareil de cuisson, caractérisé en ce qu'il comporte des éléments électriques de puissance pour élever la température des aliments à cuire, notamment des lampes halogènes, des résistances électriques ou des inductances de puissance et un clavier, selon l'invention, connectés à un dispositif de commande de mise en marche, d'extinction et de réglage de la puissance moyenne de chauffage des aliments par lesdits éléments électriques de puissance.

L'invention a également pour objet un appareil de cuisson, caractérisé en ce que ledit appareil est une table de cuisson comportant une plaque supérieure en vitro-céramique dont une première face reçoit le contenant des aliments à cuire, notamment des casseroles, des antennes d'émission et des antennes de réception du clavier étant disposées à proximité de la seconde face de la plaque en vitro-céramique.

L'invention a également pour objet un appareil de cuisson, caractérisé en ce que les dispositifs de commande de mise en marche, d'extinction et de réglage de la puissance moyenne de chauffage comportent des IGBT.

L'invention a également pour objet un appareil de cuisson, caractérisé en ce qu'il comporte des interrupteurs électroniques assurant, dans un état bloqué, la coupure de l'alimentation électrique des éléments électriques de puissance et, dans un état passant, I'établissement de l'alimentation électrique des éléments électriques de puissance et des moyens de commande pour assurer le passage de l'état bloqué à l'état passant des interrupteurs sensiblement au début de certaines alternances.

L'invention sera mieux comprise au moyen de la description ci-après et des figures annexées données comme des exemples non limitatifs, et sur lesquelles :
- la figure 1 est un schéma d'un premier exemple de réalisation d'une touche d'un clavier selon la présente invention ;
- la figure 2 est un schéma d'un deuxième exemple de réalisation d'une touche d'un clavier selon la présente invention ;
- la figure 3 est un schéma d'un premier exemple de réalisation d'un clavier selon la présente invention ;
- la figure 4 est un schéma de l'exemple préféré de réalisation d'un clavier selon la présente invention ;
- la figure 5 est une vue en plan d'une première face d'un circuit imprimé mis en oeuvre dans un exemple de réalisation d'un clavier selon la présente invention ;
- la figure 6 est une vue en plan d'un exemple de réalisation de la seconde face du circuit imprimé de la figure 5 ;
- la figure 7 est un schéma de la variante de réalisation préférée d'un circuit de commande d'un élément chauffant d'un appareil de cuisson selon la présente invention.

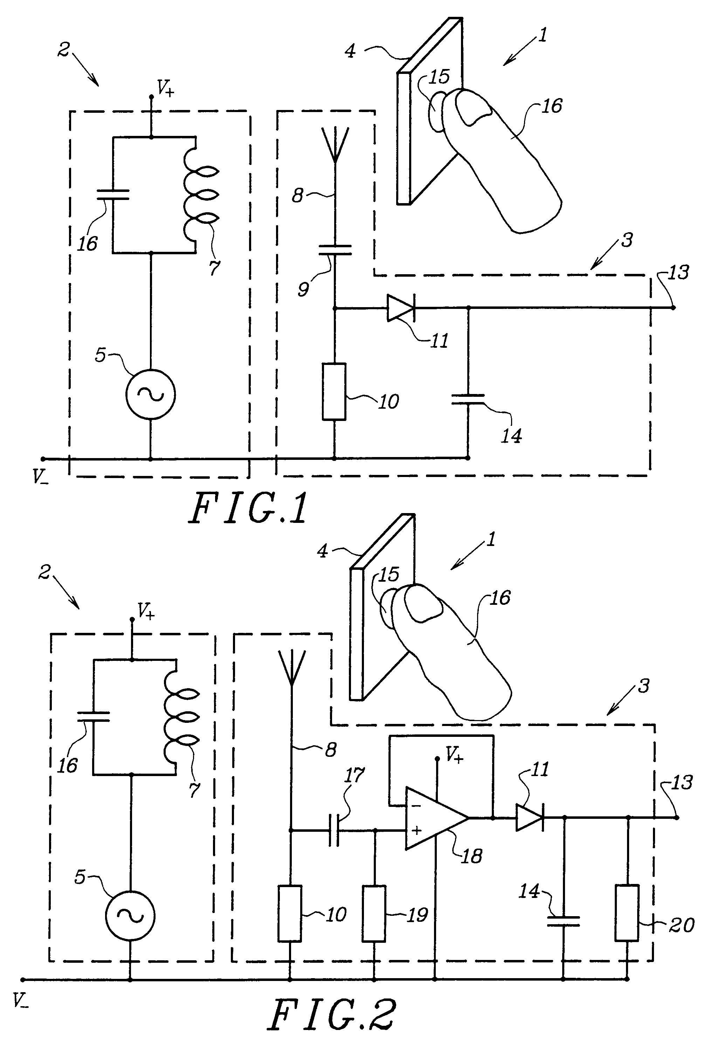

Sur les figures 1 à 7, l'on a utilisé les mêmes références pour désigner les mêmes éléments.

Sur la figure 1, l'on peut voir un premier exemple de réalisation d'une touche d'un clavier selon la présente invention comportant un circuit d'émission 2 et un circuit de réception 3 placés derrière une paroi d'étanchéité 4 formée, par exemple, par une plaque vitro-céramique. Le circuit d'émission comporte un oscillateur 5 travaillant avantageusement à une fréquence comprise entre 150 kHz et 1,2 MHz ou plus dont la sortie est connectée à un condensateur 6 et une antenne d'émission 7 connectée en parallèle entre la sortie de l'oscillateur 5 et la borne + de l'alimentation électrique. Le circuit de réception 3 comporte une antenne de réception 8 reliée à travers un condensateur 9 et une résistance 10 à la borne - de l'alimentation électrique. Le point d'interconnexion du condensateur 9 et de la résistance 10 est relié par l'intermédiaire d'une diode 11 à une borne 13 formant la sortie de la touche 1 selon la présente invention. Un condensateur 14 relie la sortie de la diode 11 à la borne - de l'alimentation électrique.

Un oscillateur 5 provoque la charge et la décharge périodiques, avantageusement avec une fréquence comprise entre 150 kHz et 1,2 MHz du condensateur 6, la self-inductance 7 rayonnant un rayonnement électromagnétique à cette même fréquence. Le rayonnement est capté par l'antenne 8, et un signal d'un niveau par exemple égal à 2 V est délivré au point 13. En cas de présence d'un doigt 16 de l'opérateur au droit de l'antenne de réception, le niveau du signal capté était atténué entre 0,16 V et 0,3 V.

La sensibilité du dispositif selon l'invention peut encore être améliorée par un dépôt métallique 15 sur la touche, par exemple par une sérigraphie métallique sur la face supérieure de la plaque vitro-céramique d'une table de cuisson.

Lorsqu'un opérateur place son doigt 16 en vis à vis de l'antenne 8, il perturbe la transmission des ondes électromagnétiques entre la self-inductance 7 et l'antenne de réception 8. Il en résulte une perturbation, avantageusement une atténuation caractéristique de la présence d'un doigt de commande sur la touche 1 selon la présente invention. Il est à noter que la présence d'une casserole ou d'un autre ustensile de cuisine ne provoque pas de variation du niveau du signal.

Le rapport cyclique du générateur haute fréquence de contrôle va conditionner le niveau moyen de fonctionnement de chacune des touches composant ledit clavier.

Sur la figure 2, l'on peut voir une variante de réalisation du dispositif de la figure 1 dont les circuits de réception 3 comportent des moyens d'isolation du point de sortie 13 par rapport à l'antenne de réception 8. La sortie de l'antenne de réception 8 est reliée, d'une part, par la résistance 10 à la borne - de l'alimentation électrique et, d'autre part, par un condensateur 17 à une entrée + d'un amplificateur opérationnel 18 et à une résistance 19 elle-même reliée à la borne - de l'alimentation électrique. La sortie de l'amplificateur opérationnel 18 est reliée, d'une part, à son entrée - et, d'autre part, par l'intermédiaire de la diode 11 à la borne de sortie 13 du circuit de réception 3. La borne de sortie 13 est reliée par un condensateur 14 et une résistance 20 mises en parallèle à la borne - de l'alimentation électrique.

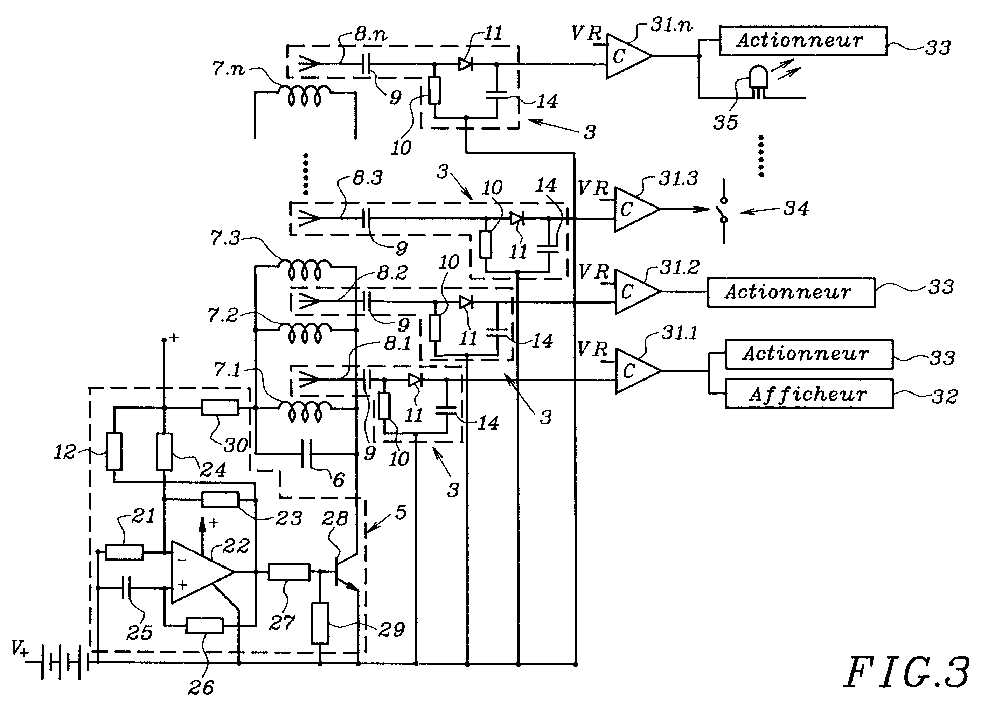

Sur la figure 3, l'on peut voir un premier exemple de réalisation d'un clavier selon la présente invention. L'oscillateur 5 comporte une résistance 21 dont l'entrée est reliée à la borne - de l'alimentation électrique et dont la sortie est reliée en parallèle à l'entrée + d'un amplificateur opérationnel 22, à l'entrée d'une résistance 23 et à l'entrée d'une résistance 24. L'entrée d'un condensateur 25 est reliée à la borne - de l'alimentation électrique, sa sortie étant reliée en parallèle à l'entrée - de l'amplificateur opérationnel 22 et à l'entrée d'une résistance 26. La sortie de l'amplificateur opérationnel 22 est reliée en parallèle aux sorties des résistances 23 et 26, à l'entrée d'une résistance 27 et connectée à la borne + de l'alimentation électrique par une résistance de polarisation 12. La sortie de la résistance 27 est reliée en parallèle à la base d'un transistor NPN 28 et à l'entrée d'une résistance 29. La sortie de la résistance 29 ainsi que l'émetteur du transistor 28 sont reliés à la borne - de l'alimentation électrique. Le collecteur du transistor 28 est relié en parallèle à l'entrée du condensateur 6 et à l'entrée des n self-inductances 7.1 à 7.n des n touches du clavier. La sortie du condensateur 6 et des self-inductances 7.1 à 7.n sont reliées à l'entrée d'une résistance 30. La sortie de la résistance 30 est reliée à la sortie de la résistance 24 et à la borne + de l'alimentation électrique. Chacune des n antennes de réception 8.1 à 8.n des n touches du clavier est connectée à une première entrée d'un comparateur 31 par l'intermédiaire de son circuit de réception 3. Chaque comparateur 31 reçoit sur sa seconde entrée une tension de référence VR. La sortie de chaque comparateur 31 est reliée aux dispositifs à commander par la touche correspondante. Par exemple, la sortie du comparateur 31.1 est reliée à un afficheur 32 et à un actionneur 33 ; la sortie du comparateur 31.2 est reliée à un actionneur 33 ; la sortie du comparateur 31.3 est reliée à la commande d'un commutateur 34. La sortie du comparateur 31.n est reliée, d'une part, à une diode électro-luminescente 35 et, d'autre part, à un actionneur 33. Dans une variante de réalisation, les sorties des comparateurs 31 sont reliées à un codeur ou constituent les conducteurs d'un bus de type informatique.

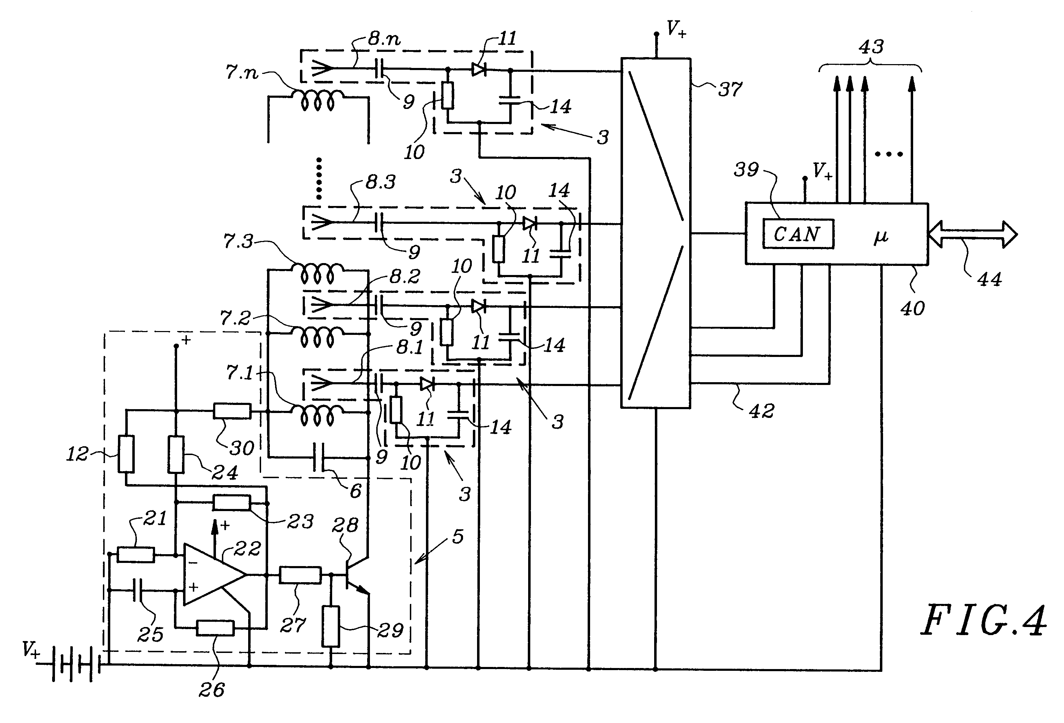

Sur la figure 4, l'on peut voir une variante de réalisation du clavier de la figure 3 dans laquelle les sorties des antennes de réception 8.1 à 8.n sont reliées aux entrées d'un multiplexeur 37 analogique.

La sortie de données du multiplexeur analogique 37 est reliée à l'entrée d'un convertisseur analogique numérique 39 d'un micro-contrôleur 40. En variante, l'on met en oeuvre un micro-processeur associé à un convertisseur analogique numérique externe. Avantageusement, les lignes d'adresses 42 relient le micro-contrôleur 40 au multiplexeur 37 permettant un balayage, par exemple cyclique et synchrone, des touches par le microprocesseur ou le micro-contrôleur 40. Les signaux de commande élaborés à partir des frappes des touches du clavier selon la présente invention sont disponibles sur les lignes de commande 43 et/ou sur le bus 44.

Le micro-contrôleur 40 est associé à un programme de fonctionnement, avantageusement stocké dans une mémoire permanente, par exemple de type mémoire permanente programmable (PROM, EPROM ou EEPROM en terminologie anglo-saxonne). La mémoire de programme peut être interne au micro-contrôleur 40 ou constituer un boîtier de circuit intégré distinct.

Avantageusement, le clavier selon la présente invention comporte des moyens de validation de la détection d'un doigt 16 de l'opérateur sur une touche mettant en oeuvre une fenêtre de valeurs de niveau du signal délivré aux points 13 des diverses touches, bien que pouvant être réalisée par le micro-contrôleur 40. La fenêtre de validation correspond, par exemple, à une tension à la borne 13 comprise entre 100 mV et 500 mV, entre 0 et 500 mV, entre 20 mV et 600 mV ou entre 150 mV et 350 mV. Avantageusement, la fenêtre inclus aussi bien le fonctionnement avec la pastille métallique 15 que sans cette pastille. L'on se prémunit ainsi contre la destruction de la pastille exposée à l'environnement sévère.

La mise en oeuvre de la fenêtre de validation de la détection d'un doigt 16 permet d'éviter une commande accidentelle. Par exemple, lorsque de l'eau est renversée sur une ou plusieurs touches du clavier, le niveau du signal aux bornes 13 correspondantes est sensiblement égal à 2 V. Par contre, si dans cette flaque d'eau, l'on plonge un doigt ou une main à un endroit ne se trouvant pas au droit d'une touche, le niveau du signal passe à 0,8 V. Ce signal ne sera pas validé car il ne se trouve pas dans la fenêtre de validation. Le clavier selon la présente invention peut être muni de protocole de validation en fonction d'appui sur une pluralité de touches et/ou une séquence d'appuis sur des touches. Par exemple, l'appui simultané sur deux touches incompatibles n'est pas validé.

Par l'intermédiaire du multiplexeur 37, le micro-contrôleur 40 effectue un balayage avantageusement circulaire des n touches du clavier. Dans une première variante de réalisation du clavier selon la présente invention, le micro-contrôleur 40 envoie, par l'intermédiaire du bus 44 ou des lignes de commande 43, l'information concernant les touches du clavier actionnées. Dans une variante avantageuse du dispositif selon la présente invention, le micro-contrôleur 40 interprète les commandes à exécuter en fonction des séquences des touches et/ou des combinaisons des touches actionnées. Il en déduit les mesures à prendre. L'on définit un protocole d'augmentation ou de diminution de puissance par incrémentation d'un compteur Par exemple, la puissance d'un foyer radian doit dépendre de la puissance initiale ainsi que du temps pendant lequel une touche d'augmentation ou une touche de diminution de la puissance a été actionnée par le doigt d'un opérateur. Ainsi, par exemple, lorsqu'une touche de validation a été actionnée, suivie par l'activation pendant 250 ms d'une touche d'augmentation de la puissance d'un foyer radian, le micro-contrôleur 40 envoie au circuit de commande du foyer radian concerné la consigne d'augmenter la puissance moyenne d'une valeur prédéterminée ou la consigne de la valeur de la nouvelle puissance moyenne à appliquer à ce foyer radian.

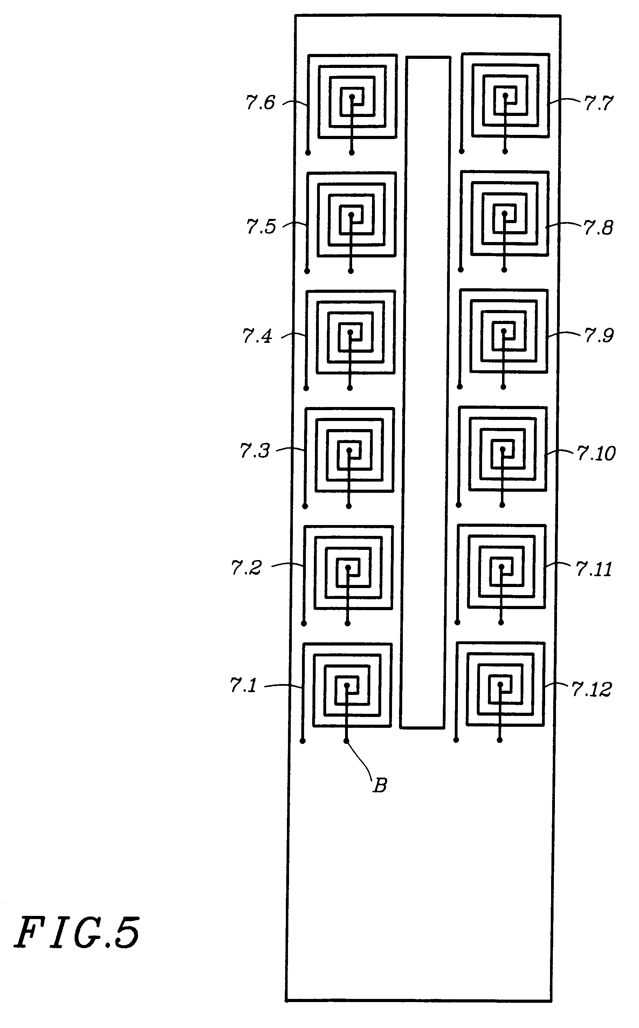

Sur la figure 5, l'on peut voir les self-inductances 7.1 à 7.n (dans l'exemple illustré n étant égal à 12) imprimées sur une première face d'un circuit imprimé. Dans l'exemple illustré, les self-inductances sont composées par des spirales carrées, étant bien entendu que d'autres formes, comme par exemple des spirales logarithmiques, ne sortent pas du cadre de la présente invention.

Dans un premier exemple de réalisation, le circuit imprimé est monocouche et la sortie de ces self-inductances, S, s'effectue sur la face opposée du circuit imprimé. Dans un tel cas, les antennes de réception correspondantes 8.1 à 8.n sont rectilignes avec un décrochement évitant le contact avec la sortie.

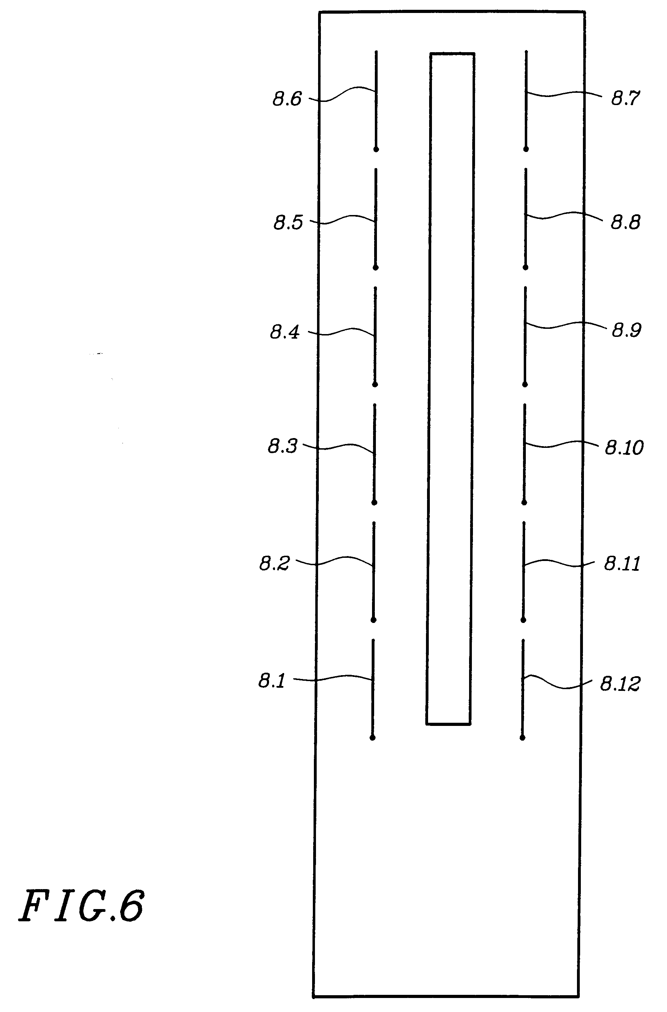

Dans une seconde variante de réalisation avantageuse illustrée sue la figure 5, le circuit imprimé est multicouches. Dans un tel cas, la sortie self-inductances 7.1 à 7.n s'effectue sur la même face du circuit par une branche B Isolée et les antennes de réception 8.1 à 8.n sont avantageusement rectilignes, comme illustré sur la figure 6.

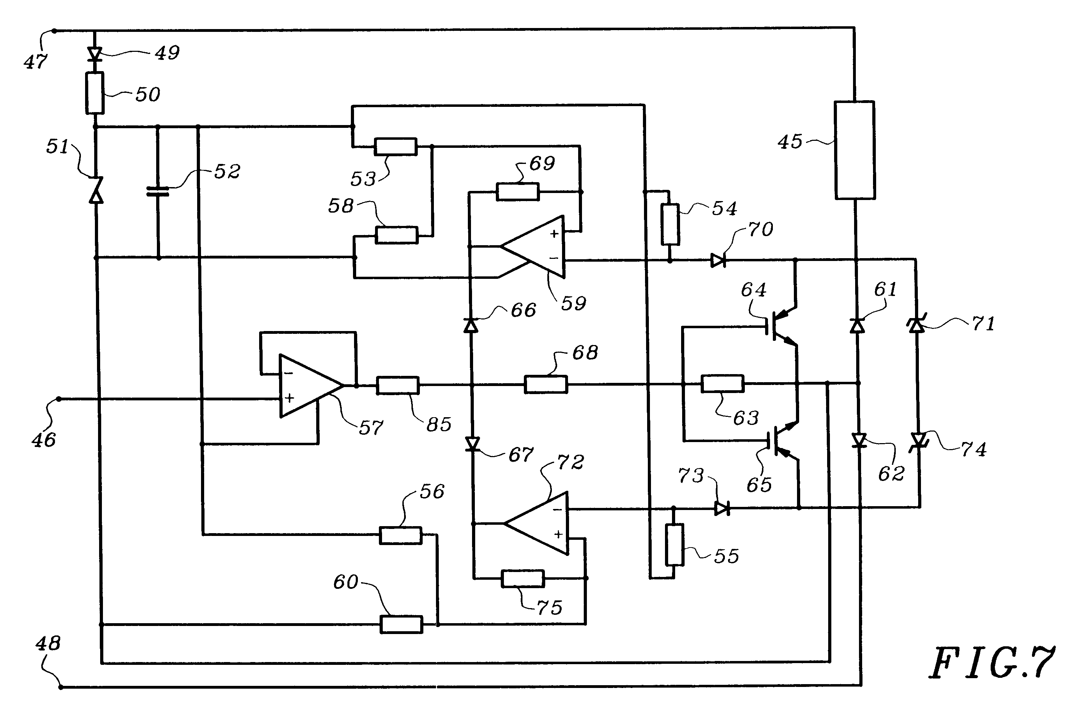

Sur la figure 7, l'on peut voir un tel circuit de commande particulièrement avantageux, par exemple d'un foyer radian et/ou halogène 45 pour table de cuisson comprenant une plaque supérieure en vitro-céramique. Les dispositifs de commande comportent une borne de commande 46 raccordée à une des lignes 43 du micro-contrôleur 40 ou à une borne d'un micro-contrôleur spécifique, une borne 47 raccordée à la phase d'une source de courant alternatif et une borne 48 raccordée au neutre d'une source de courant alternatif. La borne 47 est connectée en parallèle à l'entrée d'une diode 49 et à l'entrée de la charge 45 à alimenter. La sortie de la diode 49 est reliée à l'entrée d'une résistance 50. La sortie de la résistance 50 est reliée en parallèle à l'entrée d'une diode Zener 51, à la borne + d'un condensateur chimique 52, à l'entrée d'une résistance 53, à l'entrée d'une résistance 54, à l'entrée d'une résistance 55, à l'entrée d'une résistance 56 et à l'entrée de commande d'un amplificateur opérationnel 57. Les sorties de la diode Zener 51 et l'armature - du condensateur 52 sont reliées à l'entrée d'une résistance 58, à l'entrée de commande d'un amplificateur opérationnel 59, à l'entrée d'une résistance 60, aux entrées des diodes de puissance 61 et 62, à l'entrée d'une résistance 63 et aux émetteurs des composants dits "Integrated Gate Bipolar Transistor (IGBT)" 64 et 65. L'entrée de commande 46 est reliée à la borne + de l'amplificateur opérationnel 57. La sortie de l'amplificateur opérationnel 57 est reliée, d'une part, à l'entrée - dudit amplificateur opérationnel et à l'entrée d'une résistance 85. La sortie de la résistance 85 est reliée aux entrées des diodes 66 et 67, et à l'entrée d'une résistance 68. La sortie de la résistance 68 est reliée à la sortie de la résistance 63 ainsi qu'aux grilles des composants IGBT 64 et 65. La sortie de la diode 66 est reliée à la sortie de l'amplificateur opérationnel 59 ainsi qu'à l'entrée d'une résistance 69. La sortie de la résistance 69 est reliée aux sorties des résistances 53 et 58 ainsi qu'à l'entrée + de l'amplificateur opérationnel 59. La sortie de la résistance 54 est reliée à l'entrée - de l'amplificateur opérationnel 59 et à l'entrée d'une diode 70. La sortie de la diode 70 est reliée au collecteur de l'IGBT 64, à la sortie de la diode 61, à la sortie de la charge 45 à piloter et à la sortie d'une diode transil 71. La sortie de la résistance 55 est reliée à l'entrée - d'un amplificateur opérationnel 72 et à l'entrée d'une diode 73. La sortie de la diode 73 est reliée au collecteur de l'IGBT 65, à la sortie de la diode 62 et à la sortie d'une diode transil 74. L'entrée de la diode transil 74 est reliée à l'entrée de la diode transil 71. Les diodes transils monodirectionnelles 71 et 74 peuvent être remplacées par une diode transil bidirectionnelle. Les sorties des résistances 56 et 60 sont reliées à l'entrée + de l'amplificateur opérationnel 72 et à l'entrée d'une résistance 75. La sortie de la résistance 75 est reliée à la sortie de l'amplificateur opérationnel 72 et à la sortie de la diode 67.

Lorsqu'un courant électrique disponible à la borne 46 alimente l'entrée + de l'amplificateur opérationnel 57, pendant les alternances positives, un courant de puissance disponible à la borne neutre 48, passe dans l'IGBT 65, la diode 61, la charge alimentée 45 et la borne de phase 47. Pendant les alternances négatives, le courant de puissance passe par la borne 47, la charge alimentée 45, l'IGBT 64, la diode 62 et la borne neutre 48.

Les diodes transils 71 et 74 assurent l'écrêtage sur des charges inductives et ainsi assurent la protection du dispositif de la figure 7.

Il est à noter que les composants IGBT pourraient être remplacés par des transistors métal-oxyde semi-conducteur (MOS) de puissance. Toutefois, il en résulterait un mauvais rendement thermique, dans la mesure où à l'état passant, les transistors de puissance MOS ont des pertes thermiques proportionnelles à
R I², R étant la résistance drain source et I l'intensité du courant traversé. Par contre, les composants IGBT ont deux pertes thermiques égales V x I, V étant la tension entre l'émetteur et le collecteur qui peut être rendue très basse, par exemple comprise entre 1,5 et 1,8 V.

Dans l'exemple préféré de réalisation illustré sur la figure 4, l'on a utilisé les composants suivants :
- résistances :
   10 2MΩ
   12 1 kΩ
   21 47 kΩ
   23 150 kΩ
   24 150 kΩ
   26 150 kΩ
   27 1 kΩ
   29 10 kΩ
   30 100 Ω
- transistor 28 : BC 574 ou BC 337
- condensateurs :
   6 100 nF
   9 1 nF
   14 1 nF
   25 27 pF
- amplificateur opérationnel 22 : LM 311
- multiplexeur 37 : HC 4051
- micro-contrôleur 40 : PIC 16 C71 Microchips.

Dans l'exemple du circuit de commande de la figure 7, l'on a mis en oeuvre les éléments suivants :
- résistances **:**
   50 33 kΩ 0,5 W
   53 100 kΩ
   54 100 kΩ
   55 100 kΩ
   56 100 kΩ
   58 10 kΩ
   60 10 kΩ
   63 100 kΩ
   65 10 kΩ
   68 0 Ω
   69 1 MΩ
   25 1 MΩ
- diodes **:**
   11 : 1N 4148
   49 1N 4004
   61 P600 G
   62 P600 G
   70 1N 4004
   73 1N 4004
   51 BZ x 55 C18
   71
   GEMOV V2 250
   74
- amplificateurs opérationnels :
   57
   59 LM 324
   72
- IGBT :
   64 STGH 10 N 50 A ou IGTP 10 N 40
   65 STGH 10 N 50 A ou IGTP 10 N 40

La présente invention s'applique à la réalisation des claviers étanches résistants à un environnement sévère et ne risquant pas de perturber ou de contaminer un milieu extérieur. Elle s'applique notamment à la réalisation de claviers pour milieux où il existe un risque d'explosion, pour automates programmables ou ordinateurs industriels ainsi que pour les salles propres. Elle s'applique également aux appareils électro-domestiques, comme par exemple, claviers de commande par convecteurs, tableaux de bord pour machines à laver, lave-vaisselles, chaudière ou analogues.

Elle s'applique aussi aux claviers de commande d'une automobile ou de ses équipements notamment électro-acoustiques.

Elle s'applique également aux claviers pour composer un code d'accès et aux automates bancaires.

L'invention s'applique principalement à la réalisation de claviers pour tables de cuisson à plaques supérieures en vitro-céramiques et à des fours pour cuisson d'aliment.

## Revendications

1. Clavier de commande comportant un générateur haute fréquence ou un générateur radio fréquence (5) notamment un générateur accordé sur une fréquence comprise entre 150 kHz et 1,2 MHz et au moins une touche comprenant au moins une antenne d'émission (7) d'ondes électromagnétiques hautes fréquences ou d'ondes radio électriques raccordées audit générateur (5), caractérisé en ce que ladite touche comporte une antenne de réception (8) placée au droit de l'emplacement de détection de la présence d'un doigt (16) de commande et des moyens de comparaison (31, 40) du niveau du signal recueilli par ladite antenne de réception (8) par rapport à une valeur de référence ou à un intervalle de valeurs de référence.

2. Clavier selon la revendication 1, caractérisé en ce que l'amplitude du signal capté par l'antenne de réception est réduite par la présence d'un doigt (16) placé au droit de l'emplacement de détection.

3. Clavier selon la revendication 1 ou 2, caractérisé en ce que l'antenne d'émission est une self-inductance imprimée sur une première face d'un circuit imprimé et en ce que l'antenne de réception (8) est imprimée en vis à vis sur la seconde face du circuit imprimé.

4. Clavier selon la revendication 1, 2 ou 3, caractérisé en ce que la sortie du générateur haute fréquence ou radio fréquence (5) est connectée en parallèle aux entrées d'un condensateur (6) et d'une self-inductance (7) formant une antenne d'émission, les sorties du condensateur (6) et de la self-inductance (7) étant reliées à une première borne d'une première polarité d'une alimentation électrique, et en ce que l'antenne de réception (8) est connectée à l'entrée d'un condensateur (9) dont la sortie est connectée en parallèle à l'entrée d'une première résistance (10) et à l'entrée d'une diode (11), la sortie de la première résistance (10) étant connectée à une deuxième borne d'une seconde polarité de l'alimentation électrique, la sortie de la diode (11) étant connectée à la deuxième borne de seconde polarité de l'alimentation électrique par un condensateur (14) et aux moyens de comparaison du niveau du signal (31,40) à une valeur de référence (VR).

5. Clavier selon l'une quelconque des revendications précédentes, caractérisé en ce que les moyens de comparaison (30, 41) du niveau du signal recueilli par l'antenne de réception (8) d'une touche par rapport à une valeur de référence comporte un comparateur (31).

6. Clavier selon l'une quelconque des revendications 1 à 3, caractérisé en ce que les moyens de comparaison (31, 40) du niveau du signal recueilli par une antenne de réception (8) par rapport à une valeur de référence comportent des moyens de numérisation du signal et un microprocesseur ou un micro-contrôleur (40).

7. Clavier selon la revendication 6, caractérisé en ce qu'il comporte un multiplexeur (37) dont les entrées sont connectées aux diverses antennes de réception (8) des diverses touches du clavier et dont la sortie est connectée audit micro-contrôleur ou micro-processeur (40).

8. Appareil de cuisson, caractérisé en ce qu'il comporte des éléments électriques de puissance (45) pour élever la température des aliments à cuire, notamment des lampes halogènes, des résistances électriques ou des inductances de puissance et un clavier, selon l'une quelconque des revendications précédentes, connectés à un dispositif de commande de mise en marche, d'extinction et de réglage de la puissance moyenne de chauffage des aliments par lesdits éléments électriques de puissance.

9. Appareil de cuisson selon la revendication 8, caractérisé en ce que ledit appareil est une table de cuisson comportant une plaque supérieure en vitro-céramique dont une première face reçoit le contenant des aliments à cuire, notamment des casseroles, des antennes d'émission (7) et des antennes de réception (8) du clavier étant disposées à proximité de la seconde face de la plaque (4) en vitro-céramique.

10. Appareil de cuisson selon la revendication 8 ou 9, caractérisé en ce que les dispositifs de commande de mise en marche, d'extinction et de réglage de la puissance moyenne de chauffage comportent des IGBT.

11. Appareil de cuisson selon la revendication 8, 9, ou 10, caractérisé en ce qu'il comporte des interrupteurs électroniques assurant, dans un état bloqué, la coupure de l'alimentation électrique des éléments électriques de puissance (45) et, dans un état passant, I'établissement de l'alimentation électrique des éléments électriques de puissance (45) et des moyens de commande pour assurer le passage de l'état bloqué à l'état passant de interrupteurs (64, 65) sensiblement au début de certaines alternances.
